# EUROPEAN PATENT SPECIFICATION

(11) **EP 1 441 234 B1**
(45) Date of publication and mention of the grant of the patent: **24.04.2013**
(21) Application number: 04250334.2
(22) Date of filing: 22.01.2004
(51) Int. Cl.: G01R 33/05

(54) **Fluxgate sensor integrated in semiconductor substrate and method for manufacturing the same**
In einem Halbleitersubstrat integrierte Förstersonde und dessen Herstellungsverfahren
Sonde à noyau saturable, intégrée dans un substrat semiconducteur et procédé de fabrication

(30) Priority: 25.01.2003 KR 2003005078
(43) Date of publication of application: 28.07.2004
(73) Proprietor: Samsung Electronics Co., Ltd., Suwon-si, Gyeonggi-do, 443-742 (KR)
(72) Inventor: Park, Hae-seok, 519-1505 Samsung Raemian 5th Apt., Yongin-si, Gyeonggi-do (KR); Choi, Sang-on, Suwon-si, Gyeonggi-do (KR); Shim, Dong-sik, Seoul (KR); Na, Kyung-won, Suji-eub, Yongin-si, Gyeonggi-do (KR)
(74) Representative: Ertl, Nicholas Justin

(56) References cited:
- US-B1- 6 429 651
- DONG-SIK SHIM ET AL: "Micro fluxgate sensor using solenoid driving and sensing coils" OPTOELECTRONIC AND MICROELECTRONIC MATERIALS AND DEVICES, 2002 CONFERENCE ON 11-13 DEC. 2002, PISCATAWAY, NJ, USA,IEEE, 11 December 2002 (2002-12-11), pages 237-240, XP010662352 ISBN: 0-7803-7571-8
- LIAKOPOULOS T M ET AL: "A micro-fluxgate magnetic sensor using micromachined planar solenoid coils" SENSORS AND ACTUATORS A, ELSEVIER SEQUOIA S.A., LAUSANNE, CH, vol. 77, no. 1, 28 September 1999 (1999-09-28), pages 66-72, XP004244548 ISSN: 0924-4247

## Description

### BACKGROUND

The present invention generally relates to a fluxgate sensor, and more particularly, to a fluxgate sensor integrated in a semiconductor substrate and a manufacturing method thereof.

Existence of magnetic energy has been proven through various physical phenomena, and a fluxgate sensor enables a human to indirectly perceive magnetic energy, as it is unperceivable to human sense organs such as eyes and ears. As for the fluxgate sensor, a magnetic sensor employing soft magnetic body and coil have been used for a long time. The magnetic sensor is made by winding a coil around a relatively large bar-shaped core or an annular core formed of a soft magnetic ribbon. Also, an electronic circuit is employed to obtain a magnetic field in proportion to the measured magnetic field.

The conventional fluxgate sensor, however, has the following problems. That is, due to the structure of the conventional fluxgate sensor in which the coil is wound around a large bar-shaped core or an annular core made of soft magnetic ribbon, production costs are high, and the volume of the overall system is large.

Also, magnetic flux leakage by core is inevitable in the flux change generated by the excitation coil. Accordingly, high sensitivity cannot be guaranteed.

The article "A micro-fluxgate magnetic sensor using micromachined planar solenoid coils" byT. Liakopoulos et al., Sensors and Actuators vol. 77, no. 1 (1999) pp 66-72 (XP004244548) discloses a rectangular bar soft core with excitation and pick up coils on the two long bars of the rectangle.

### SUMMARY OF THE INVENTION

According to the invention, there is provided a fluxgate sensor as claimed in claim 1.

The present invention has been made to overcome the above-mentioned problems of the prior art. The invention provides a high sensitivity fluxgate sensor integrated in a semiconductor substrate capable of not only reducing overall volume of a system, but also detecting a magnetic field with more accuracy.

The sensor of the invention can also prevent an induction wave in a flux change detecting coil when the external magnetic field is measured as zero.

The soft magnetic core can have two bars placed on the same plane in parallel relation. The two bars are then positioned such that the length thereof lies in the direction of magnetic field detection. Meanwhile, the soft magnetic core can be formed as a rectangular-ring, and in this case also, the rectangular-ring is positioned to have its length in the direction of the magnetic field detection.

The excitation coil can have a structure of alternately winding the two bars substantially in a figure of 8 pattern. Alternatively, the excitation coil can have a structure of winding the two bars in series and substantially in a solenoid pattern. When a rectangular-ring is used for the soft magnetic core, the excitation coil either has a structure of alternately winding two opposite sides of the rectangular-ring in the direction of magnetic field detection substantially in a figure of 8 pattern, or has a structure of winding the two opposite sides in series.

The pick-up coil is stacked on the excitation coil that has a structure of alternately winding the two bars or two opposite sides of the rectangular ring in the direction of magnetic field detection, altogether in a figure of 8 pattern, or a structure of winding the two bars or the two longer sides of the rectangular-ring in series in the solenoid pattern. In this case, the pick-up coil has a structure of winding the two bars or the two longer sides of the rectangular ring altogether in the solenoid pattern. Alternatively, the pick-up coil may be stacked on the excitation coil that has a structure of winding the two bars or two opposite sides of the rectangular ring in the direction of magnetic field detection, altogether in a figure of 8 pattern, or a structure of winding the two bars or the two longer sides of the rectangular-ring in series in the solenoid pattern. In this case, the pick-up coil has a structure of winding the two bars or the two longer sides of the rectangular ring respectively in the solenoid pattern.

The invention also provides a method for manufacturing a fluxgate sensor as claimed in claim 12.

The step of forming the lower portion of the pick-up coil can include the steps of forming a plurality of trenches from the upper toward the lower portion of the semiconductor substrate, in which the trenches have a high rate of section area and small pitch size, depositing by vacuum evaporation a seed layer on an upper surface of the semiconductor substrate having the plurality of trenches formed therein, plating the upper surface of the semiconductor substrate having the seed layer deposited thereon, and polishing the upper surface of the semiconductor substrate to insulate the metal filling in the plurality of trenches from each other. Alternatively, the step of forming the lower portion of the pick-up coil may include the steps of depositing a seed layer on an upper portion of the semiconductor substrate, applying a photosensitive material on an upper portion of the seed layer, and forming a plating flask through exposure and developing, plating through the plating flask, and removing the plating flask.

The step of forming the lower portion of the excitation coil, the step of forming the upper portion of the excitation coil and the step of forming the upper portion of the pick-up coil each includes the steps of applying the photosensitive material on the upper portion of the insulating layer which was deposited previously, forming a pattern by using an exposure with respect to the photosensitive material, forming a plating flask by etching the photosensitive material in accordance with the pattern, forming a seed layer on the upper portion of the semiconductor substrate in which the photosensitive material is etched in accordance with the pattern, plating the substrate in which the seed layer is formed, polishing the upper surface of the semiconductor substrate to insulate the metal filling in the etched area from each other, and removing the plating flask from the semiconductor substrate. Alternatively, the step of forming the lower portion of the excitation coil, the step of forming the upper portion of the excitation coil and the step of forming the upper portion of the pick-up coil may each include the steps of depositing a seed layer on the upper portion of the insulating layer which was deposited previously, applying a thick photo resist on the upper portion of the seed layer, forming a pattern by using an exposure with respect to the thick photo resist, forming a plating flask by etching along the pattern, plating through the plating flask, and polishing the upper surface of the semiconductor substrate to insulate the metal filling in the etched area from each other, and removing the plating flask and the seed layer at the lower portion of the plating flask from the semiconductor substrate.

With the fluxgate sensor integrated in the semiconductor substrate and a manufacturing method thereof according to the present invention, because the soft magnetic core is extended in the direction of the detection, demagnetizing field property can be reduced. Further, because the pick-up coil is stacked on the excitation coil which winds the soft magnetic core, there is no induction waves occurring in the pick-up coil. Additionally, the fluxgate sensor according to the present invention is compact-sized and low power-consuming, and is easy to integrate into various other circuits.

### BRIEF DESCRIPTION OF THE DRAWINGS

The above-mentioned objects and the feature of the present invention will be more apparent by describing the preferred embodiment of the present invention by referring to the appended drawings, in which:
FIG. 1 is a view showing a fluxgate sensor according to a first preferred embodiment of the present invention;
FIGS. 2A through 2F are waveforms for illustrating the operation of the fluxgate sensor of FIG. 1;
FIGS. 3A through 3E are sectional views taken along lines I-I and II-II of FIG. 1, showing a process of forming the fluxgate sensor of FIG 1 on the semiconductor substrate;
FIG. 4A is a plan view showing two bar-type soft magnetic cores arranged in the same plane in parallel relation, and an excitation coil of the united structure winding the two bar-type soft magnetic cores substantially in a number '8' pattern;
FIG. 4B is a plan view showing a pick-up coil of the separated structure winding the two bar-type soft magnetic cores, respectively;
FIG. 4C is a plan view showing two bar-type soft magnetic cores placed on a same plane, and the excitation coil of FIG. 4A and the pick-up coil of FIG. 4B formed on the two bar-type soft magnetic cores altogether;
FIG. 4D is a plan view showing a rectangular-ring type soft magnetic core placed in the same plane of a semiconductor substrate, with an excitation coil of the united structure formed on two longer sides of the rectangular-type soft magnetic core, and a pick-up coil respectively winding the two longer sides of the rectangular-type soft magnetic core;
FIG. 5 is a view illustrating a fluxgate sensor integrated in a semiconductor substrate according to a second preferred embodiment of the present invention;
FIG. 6A is a plan view showing two bar-type soft magnetic cores formed in the same plane in parallel relation, with an excitation coil of the separated structure winding the two bar-type soft magnetic cores;
FIG. 6B is a plan view showing two bar-type soft magnetic cores placed in the same plane in parallel relation, with a pick-up coil of the united structure winding the two bar-type soft magnetic cores;
FIG. 6C is a plan view showing two bar-type soft magnetic cores placed in the same plane, with the excitation coil and the pick-up coil of FIGS. 6A and 6B formed on the two bar-type soft magnetic cores altogether; and
FIG. 6D is a plan view showing a rectangular-ring type soft magnetic core placed in the same plane of the semiconductor substrate, with an excitation coil of the separated structure respectively winding two longer sides of the rectangular-ring type soft magnetic core, and a pick-up coil of the united structure winding the two longer sides of the rectangular-ring type soft magnetic core altogether.

### DETAILED DESCRIPTION OF THE PREFERRED EMBODIMENTS

The preferred embodiments of the present invention are described in detail with reference to the annexed drawings.

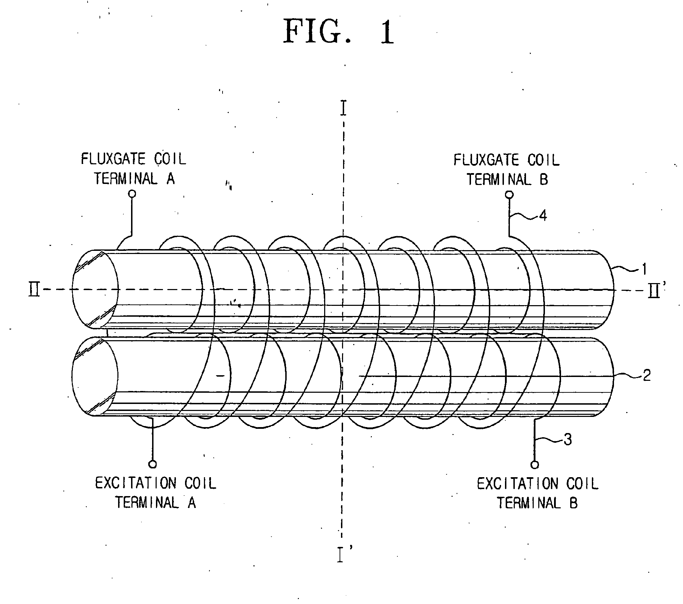

FIG. 1 is a view illustrating a fluxgate sensor integrated in a semiconductor substrate according to the first preferred embodiment of the present invention.

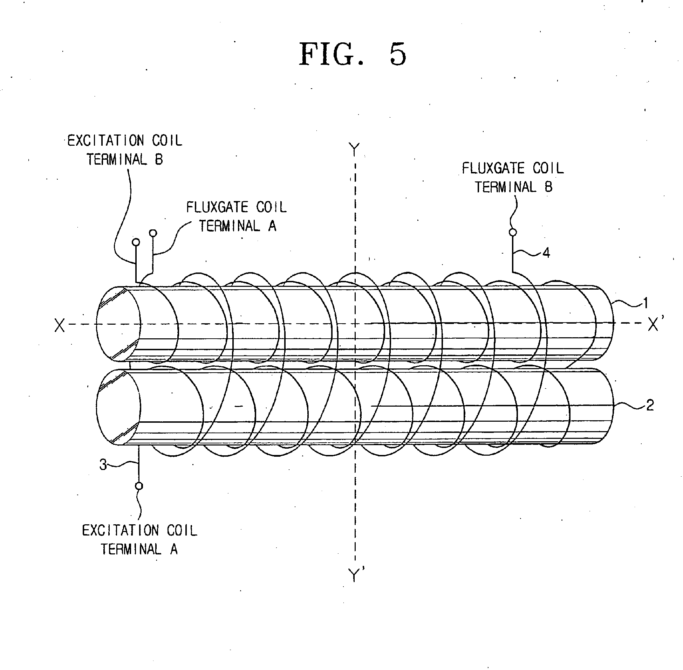

In the fluxgate sensor, first and second bar-type soft magnetic cores 1 and 2 in parallel with each other are wound by an excitation coil 3 substantially in a number '8' pattern, and a pick-up (fluxgate) coil 4 is formed over the excitation coil 3, winding the first and the second soft magnetic cores 1 and 2 altogether. As shown in FIG. 5, the excitation coil 3 can instead be wound around the first and second bar-type soft magnetic cores 1 and 2 in series. Also, the pick-up coil 4 can instead have the structure formed over the excitation coil 3, winding the first and second bar-type soft magnetic cores 1 and 2 in series.

For convenience in explanation, let us call the structure winding the first and second soft magnetic cores in a figure of 8 pattern a 'united structure', and the structure winding the first and second soft magnetic cores in series a 'separated structure'. In the case of a rectangular-ring type soft magnetic core, which will be described later in the second preferred embodiment, the structure winding two longer sides of the rectangular-ring type soft magnetic core in a number '8' pattern will be called a 'united structure', while the structure winding the two longer sides in series will be called a 'separated structure' .

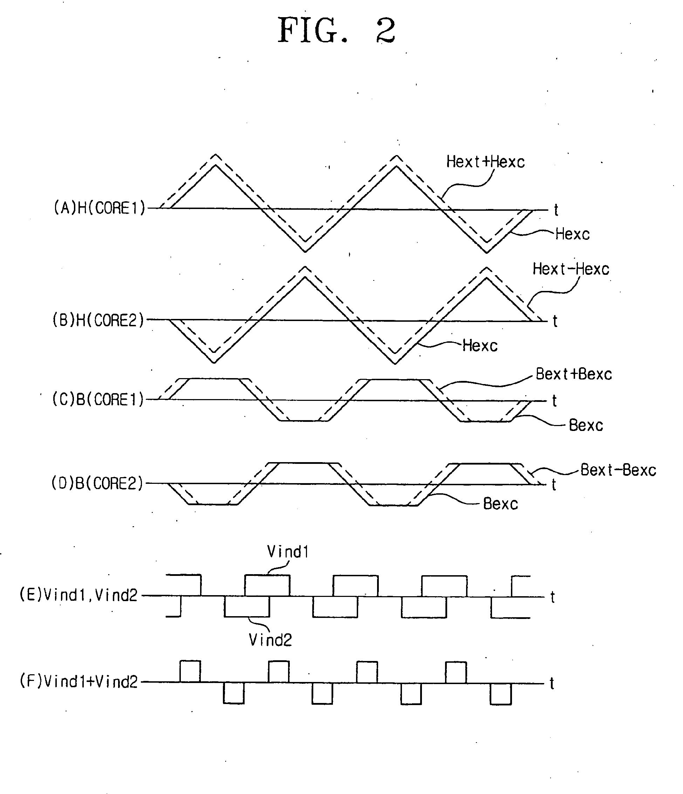

FIGS. 2A through 2F are timing views for explaining the operation of the fluxgate sensor of FIG 1. FIG. 2A is a waveform of a magnetic field generated from the first soft magnetic core 1, FIG. 2B is a waveform of a magnetic field generated from the second soft magnetic core 2, FIG. 2C is a waveform of a flux density generated from the first soft magnetic core 1, FIG. 2D is a waveform of a flux density generated from the second soft magnetic core 2, and FIGS. 2E and 2F are, respectively, waveforms of the first and second induction voltages *Vind1* and *Vind2,* and the sum (*Vind1+Vind2*) of the first and second induction voltages.

With the excitation coil 3 wound around the first and second bar-type soft magnetic cores 1 and 2 in united structure such as the number '8' pattern or in separated structure, and with the supply of AC excitation current, internal magnetic field (*Hext+Hexc*) and the flux density (*Bext+Bexc*) at the first bar-type soft magnetic core 1, and the internal magnetic field (*Hext-Hexc*) and the flux density (*Bext-Bexc*) at the second bar-type soft magnetic core 2 act in opposite directions (FIGS. 2A, 2B, 2C, 2D). Here, *Hext* is the external magnetic field, *Hexc* is the magnetic field caused by the excitation coil *3, Bext* is the flux density caused by the external magnetic field, and *Bexc* is the flux density caused by the excitation coil 3.

The pick-up coil 4 is wound to obtain the sum of variation of the magnetic flux in each of the cores 1 and 2, and to detect the flux variation by the electronic induction caused by the AC excitation current. Since the induction voltage at the pick-up coil 4 has internal magnetic fields acting in opposite directions, the induction voltage detected at the pick-up coil 4 is the result of offsetting the two symmetrically generated induction voltages *Vind1* and *Vind2* (FIG. 2F). In other words, because the external magnetic field *Hext* acts in the same direction with respect to the first and second bar-type soft magnetic cores 1 and 2, the internal magnetic fields generated from the first and second cores 1 and 2 are *Hext*+*Hexc* and *Hext-Hexc.* As shown in FIG. 2E, the voltages *Vind1* and *Vind2* are induced at the pick-up coil 4, respectively, and as shown in FIG. 2F, the two induction voltages are mutually offset, and by detecting the sum of the induction voltages *Vind1* and *Vind2,* the magnitude of the external magnetic field *Hext* can be obtained.

In the fluxgate sensor constructed as described above, it is most important to have the appropriate structure of two soft magnetic cores 1 and 2, the excitation coil 3 of the united structure winding the two soft magnetic cores 1 and 2 in a number '8' pattern, and the pick-up coil 4 winding over the excitation coil 3 in the solenoid pattern. This is because, in the absence of the external magnetic field *Hext,* such structure offsets the induction waves of the magnetic fields generated by the first and second bar-type soft magnetic cores 1 and 2, and the flux generated by the excitation coil 3 forms a closed magnetic path in the soft magnetic cores.

The soft magnetic core of FIG. 1 can take the form of a rectangular ring. In this case, the same benefit as from the bar-type soft magnetic cores can be obtained by the structure in which the excitation coil 3 is wound around two longer sides of the rectangular-ring type soft magnetic core, and the pick-up coil 4 is wound around the two longer sides in a solenoid pattern.

The detection of a magnetic field is also possible by the structure of a single bar-type core being arranged with the excitation coil and the pick-up coil. This case, however, requires more complicated signal processing of the output from the detecting coil such as amplification and filtering, because there are induction voltage waves generated at the detection coil by the excitation coil even in the absence of the external magnetic field. Accordingly, using either the two bar-type cores or a single rectangular-ring type core will allow more advantages, especially in terms of signal processing requirements.

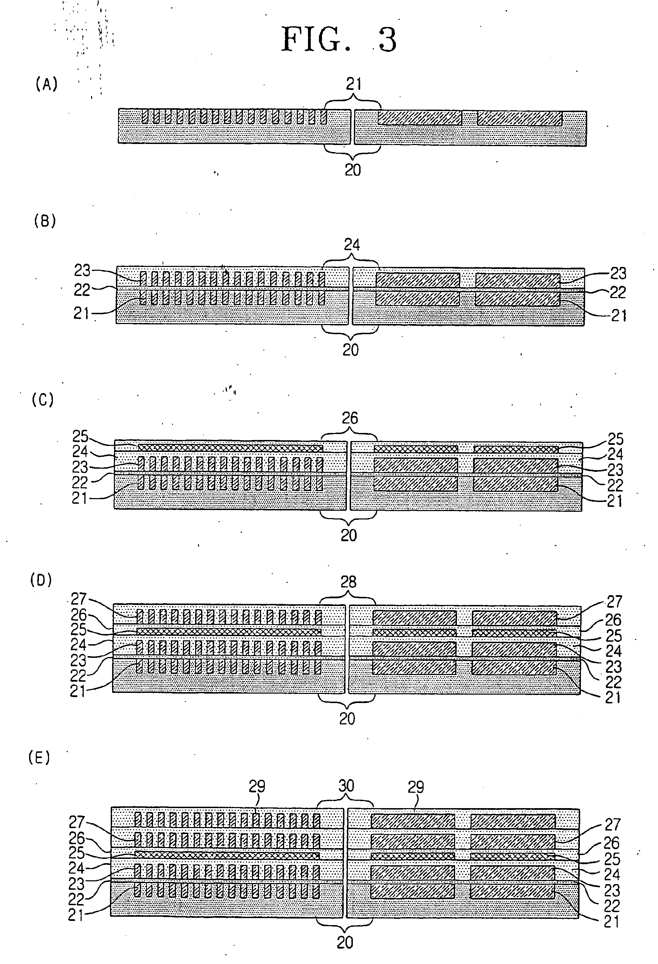

FIGS. 3A through 3E are sectional views taken on lines I-I and II-II of the fluxgate sensor of FIG. 1, for explaining the process of producing the fluxgate sensor on the semiconductor substrate. More specifically, the left sides of FIGS. 3A through 3E show the sectional views taken on line I-I, while the right sides show the sectional views taken on line II-II.

The process of producing the fluxgate sensor will be described below.

First, by using a photosensitive material and an exposure on an upper side of a semiconductor substrate 20, a lower pattern is formed for a pick-up coil. Then, through an etching, a high-section-rate trench 21 is formed along the pattern. Next, an oxide film (not shown) is formed over the etched section of the semiconductor substrate 20 for electric insulation. Then, for a metal-plating over the oxide film, a seed layer (not shown) is evaporated, and the metal layer, such as a copper layer, is formed, filling in the recessed parts of the high-section-rate trench 21 that are recessed by the etching of the upper portion of the seed layer. Then the upper portion of the substrate 20 undergoes the chemical mechanical polishing (CMP) so that the metal 23 filling in the recessed parts of the trench can be insulated from each other.

Meanwhile, the lower portion of the pick-up coil winding formed on the substrate 20 can be achieved by other methods. A first example of another method is: first, an oxide film is deposited on the semiconductor substrate 20 for insulation, and a seed layer for metal plating is formed on the oxide film. Next, after a thick photo resist is applied on the upper portion of the seed layer, a pattern is formed by exposure. And by etching along the pattern, a shape for the lower portion of the pick-up coil is obtained. Next, by plating the etched area and removing the thick photo resist and the seed layer, the lower portion of the pick-up coil winding is formed. FIG. 3A is a sectional view illustrating the lower portion 21 of the pick-up coil being formed on the semiconductor substrate in the manner as described above.

Next, on the upper portion of the substrate 20, which has the lower portion of the pick-up coil, an insulating layer 22 is deposited. Then, the lower portion 23 of the excitation coil is formed on the insulating layer 22. The lower portion 23 of the excitation coil is formed as follows: on the insulating layer 22 on the substrate 20 having the lower portion of the pick-up coil, a photosensitive material is applied, and the pattern corresponding to the lower portion 23 of the excitation coil is formed through the exposure. A plating flask is formed through etching the photosensitive material along the pattern. Then, the substrate with a seed layer (not shown) deposited thereon is plated, and in order for the metal in the etched area to be insulated, the chemical mechanical polishing (CMP) is performed. Then by removing the plating flask from the substrate, the lower portion 23 of the excitation coil is formed. In another way of forming the lower pattern for the excitation coil, a seed layer is evaporated on the upper portion of the insulating layer and a thick photo resist is applied onto the seed layer, and the lower pattern for the excitation coil is formed by exposure. Then a plating flask is formed by etching along the pattern. After that, in order for the metal in the etched area to be insulated, the chemical mechanical polishing (CMP) is performed. By removing the plating flask and the seed layer below the plating flask, the lower portion 23 of the excitation coil is formed. FIG. 3B is a sectional view illustrating the lower portion 23 of the excitation coil formed on the semiconductor substrate 20. In FIG. 3B, the insulating layer 24 is deposited on the upper portion of the lower portion 23 of the excitation coil.

Next, in order to electrically connecting the lower portion to the upper portion of the excitation coil, first via holes (not shown) are formed, and a soft magnetic core 25 is formed on the insulating layer 24 which is deposited on the lower portion of the excitation coil. In order to form the soft magnetic core 25, first, a soft magnetic film is deposited on the insulating layer 24 on the lower portion 23 of the excitation coil, and then patterned and etched. FIG. 3C is a sectional view illustrating the soft magnetic core 25 formed on the semiconductor substrate 20, showing the insulating layer 26 being deposited on the soft magnetic core 25.

Next, first via holes are secondly formed in the insulating film 26 in the locations aligned with the previously-formed first via holes, and an upper portion 27 of the excitation coil is formed on the insulating layer 26 on which the secondly-formed first via holes are formed. Since forming the upper portion 27 of the excitation coil is identical with the process of forming the lower portion 23, description thereof will be omitted. The lower portion 23 of the excitation coil is electrically connected with the upper portion 27 through the secondly-formed first via holes. FIG. 3D is a sectional view illustrating the upper portion 27 of the excitation coil formed by the above-described process. On the upper portion 27 of the excitation coil 27, there is an insulating layer 28 being deposited.

Next, second via holes (not shown) are formed in the insulating layer 28 in order to electrically connect the lower portion 21 of the pick-up coil to the upper portion 29. On the insulating layer 28 having the second via holes, an upper portion 29 of the pick-up coil is formed. Since forming the upper portion 29 of the pick-up coil is identical with the process of forming the lower portion 23 of the excitation coil which was described above, the description thereof will be omitted. By the second via holes, the upper portion 29 of the pick-up coil is electrically connected with the lower portion 21. FIG. 3E is a sectional view illustrating the pick-up coil formed on the semiconductor substrate 20, with the upper portion 29 being formed. In FIG. 3E, an insulating layer 30 is stacked on the pick-up coil.

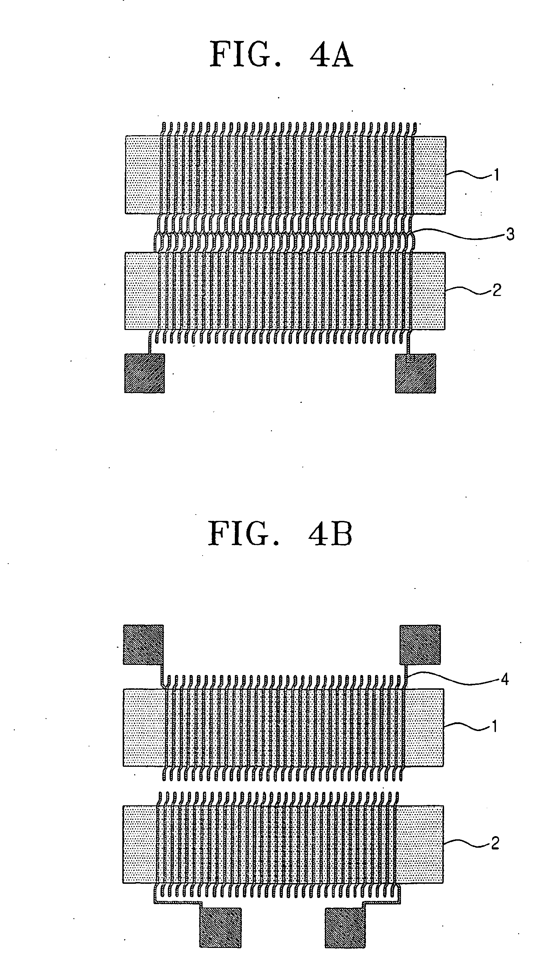

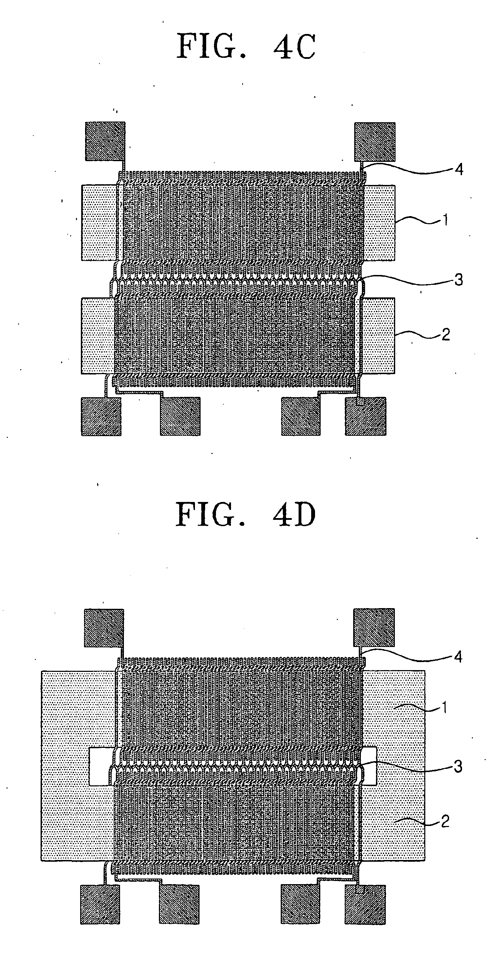

FIGS. 4A through 4C are plan views of the fluxgate sensor formed on the semiconductor substrate according to the first preferred embodiment of the present invention. More specifically, FIG. 4A is a plan view showing two bar-type soft magnetic cores 1 and 2 formed on a same plane in parallel relation, with the excitation coil 3 of the united structure formed thereon. FIG. 4B is a plan view showing two bar-type soft magnetic cores 1 and 2 with a pick-up coil 4 of the separated structure formed thereon. FIG. 4C is a plan view showing two bar-type soft magnetic cores 1 and 2 placed in the same plane in parallel relation, with the excitation coil 3 and the pick-up coil 4 of FIGS. 4A and 4B formed thereon.

FIG. 4D is a plan view showing a rectangular-ring type soft magnetic core 5 in the same plane, with an excitation coil 6 of the united structure winding two longer sides of the rectangular-ring type core, and a pick-up coil 4 of the separated structure winding the two longer sides of the rectangular-ring type soft magnetic core respectively.

FIG. 5 is a view illustrating the fluxgate sensor integrated in the semiconductor substrate according to the second preferred embodiment of the present invention. In the fluxgate sensor, the excitation coil 3 separately winds the first and second bar-type soft magnetic cores 1 and 2, respectively, and the pick-up coil 4 winds over the excitation coil 3, around the first and second bar-type soft magnetic cores 1 and 2 altogether.

Alternatively, the first and second bar-type soft magnetic cores 1 and 2 shown in FIG. 5 can take the form of a rectangular-ring, and in this case, the excitation coil separately winds the two longer sides of the rectangular-ring type soft magnetic core in the direction of magnetic field detection, and the pick-up coil winds around the two longer sides in a solenoid pattern, to thereby offset the induction voltage. Here, the pick-up coil can be wound around the two longer sides of the rectangular-ring type soft magnetic core in solenoid pattern.

As described above, the induction voltage detected at the pick-up coil according to the second preferred embodiment is similar to the induction voltage detected according to the first preferred embodiment of the present invention. Also, the induction voltage detected from the two sides are offset in the absence of an external magnetic field, which is also similar to the first embodiment.

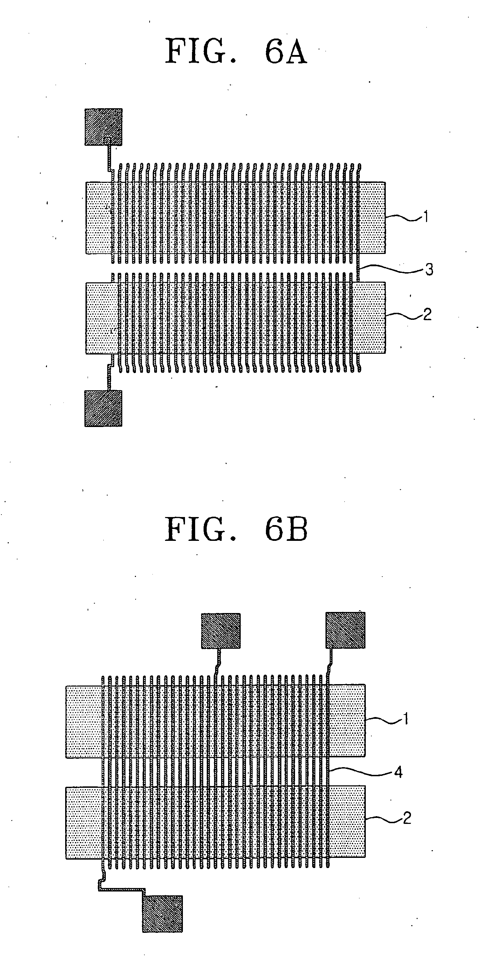

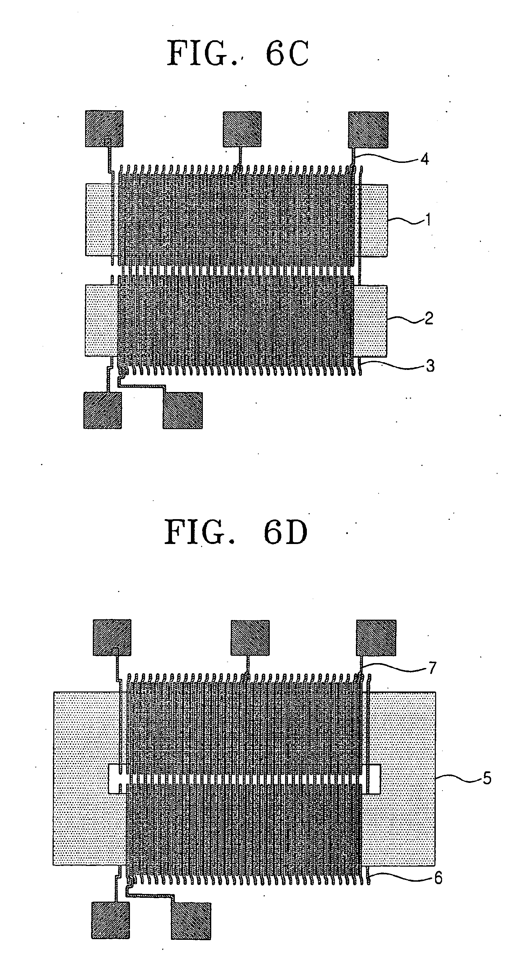

FIGS. 6A through 6C are plan views of the fluxgate sensor formed on the semiconductor substrate according to the second preferred embodiment of the present invention. More specifically, FIG. 6A is a plan view showing the excitation coil of the separated structure winding in a solenoid pattern the first and second bar-type soft magnetic cores 1 and 2 placed in the same plane in parallel relation, and FIG. 6B is a plan view showing the pick-up coil 4 of the united structure winding the first and second bar-type soft magnetic cores 1 and 2 in the same plane in parallel relation altogether. FIG. 6C is a plan view showing the excitation coil 3 and the pick-up coil 4 winding the first and second bar-type soft magnetic cores 1 and 2 in the same plane.

FIG. 6D is a plan view showing a rectangular-ring type soft magnetic core 5 placed in the same plane of the semiconductor substrate, with the excitation coil 6 of the separated structure winding two longer sides of the rectangular-ring type soft magnetic core, and the pick-up coil 4 of the united structure winding the two longer sides of the rectangular-ring type soft magnetic core altogether.

With the fluxgate sensor described above, because the soft magnetic cores construct a closed magnetic path, leakage of magnetic flux can be minimized. Also, because the excitation coil is differentially operated, the sum of driving signals can be offset, and therefore, signal processing becomes easier. Furthermore, by the construction in which the excitation coil and the pick-up coil are wound in the closed magnetic path through the use of micro-machining technology, high sensitivity is obtained.

Because the fluxgate sensor integrated in the semiconductor substrate according to the present invention can be integrated with other sensors and circuits, the overall size of the system can be greatly reduced. Further, although being compact-sized, the fluxgate sensor according to the present invention detects even the minute external magnetic fields with high sensitivity by differentially driving the voltage induced at the respective cores or sides of the cores due to the external magnetic fields. Because the system is produced by using the semiconductor integrating technology, power consumption can be greatly reduced. Also, as the fluxgate sensor according to the present invention can be produced at a cheaper price than the bar-type cores or annular cores, mass-production is enabled.

The fluxgate sensor described above can be used in various applications, such as, but not by way of limitation, a navigation system by terrestrial magnetism detection, an earth magnetism change monitor (earthquake prediction), a biological electric measurement device, and an apparatus for detecting defects in metals. As for indirect applications, the fluxgate sensor can also be used, for example, but not by way of limitation, in a magnetic encoder, a contactless potentiometer, an electric current sensor, a torque sensor, and a displacement sensor.

Although a few preferred embodiments of the present invention have been described, it will be understood by those skilled in the art that the present invention should not be limited to the described preferred embodiments, but various changes and modifications can be made within the scope of the present invention as defined by the appended claims.

## Claims

1. A fluxgate sensor, comprising:
a soft magnetic core (25) formed on a semiconductor substrate (20);
an excitation coil (27,23) winding the soft magnetic core (25) and being insulated by an insulating layer (24,20) deposited at upper and lower sides of the soft magnetic core (25); and
a pick-up coil (21,29), winding the soft magnetic core (25) and being insulated by an insulating layer (22,28) deposited at upper and lower sides (27,23) of the excitation coil, wherein the excitation coil and the pickup coil overlap each other.

2. The fluxgate sensor of claim 1, wherein the soft magnetic core comprises (25) two parallel bars (1,2) each disposed in the same plane.

3. The fluxgate sensor of claim 2, wherein the two bars (1,2) have their length in a direction of magnetic field detection.

4. The fluxgate sensor of claim 1, wherein the soft magnetic core is formed as a rectangular-ring.

5. The fluxgate sensor of claim 4, wherein the rectangular ring has its length in the direction of magnetic field detection, and wherein opposite sides of the rectangle define two parallel bars.

6. The fluxgate sensor of claim 3 or 5, wherein the excitation coil (3) has a structure of alternately winding the two bars substantially in a figure of 8 pattern.

7. The fluxgate sensor of claim 6, wherein the pick-up coil (4) has a structure formed of winding the two bars altogether substantially in a solenoid pattern.

8. The fluxgate sensor of claim 6, wherein the pick-up coil (4) has a structure formed of winding the two bars in series and substantially in a solenoid pattern.

9. The fluxgate sensor of claim 6, wherein the excitation coil has a structure of winding the two bars in series and substantially in a solenoid pattern.

10. The fluxgate sensor of claim 9, wherein the pick-up coil has a structure formed of winding the two bars altogether and substantially in a solenoid pattern.

11. The fluxgate sensor of claim 9, wherein the pick-up coil has a structure formed of winding the two bars in series and substantially in a solenoid pattern.

12. A method for manufacturing a fluxgate sensor, comprising the steps of:
forming a lower portion (21) of a pick-up coil on an upper portion of a semiconductor substrate (20);
depositing a first insulating layer (22) on the upper portion of the semiconductor substrate (20) in which the lower portion (21) of the pick-up coil is formed, and forming a lower portion (23) of an excitation coil corresponding to the pick-up coil;
depositing an insulating layer (24) on an upper surface of the lower portion (23) of the excitation coil, and firstly forming a first via holes to electrically connect with the lower portion (23) of the excitation coil;
forming a soft magnetic core (25) on an upper portion of the insulating layer that has the first via holes formed therein, to correspond in arrangement with the pick-up coil and the excitation coil;
depositing an insulating layer (26) on an upper portion of the soft magnetic core (25), and secondly forming the first via holes to electrically connect with the lower portion of the excitation coil;
forming an upper portion (27) of the excitation coil corresponding to the lower portion (23) of the excitation coil on an upper portion of the insulating layer (26) which has the secondly-formed first via holes, the upper portion (27) of the excitation coil being electrically connected with the lower portion (23) of the excitation coil;
depositing an insulating layer (28) on the upper portion (27) of the excitation coil and forming a second via holes electrically connecting with the lower portion of the pick-up coil; and
forming an upper portion (29) of the pick-up coil corresponding to the lower portion (21) of the pick-up coil on the upper portion of the insulating layer (28) which has the second via holes formed therein, the upper portion (29) of the pick-up coil being electrically connected with the lower portion (21) of the pick-up coil.

13. The method of claim 12, wherein the step of forming the lower portion (21) of the pick-up coil comprises the steps of:
forming a plurality of trenches from the upper toward the lower portion of the semiconductor substrate, the trenches having a high rate of section area and small pitch size;
depositing by vacuum evaporation a seed layer on an upper surface of the semiconductor substrate having the plurality of trenches formed therein;
plating the upper surface of the semiconductor substrate having the seed layer deposited thereon; and
polishing the upper surface of the semiconductor substrate to insulate the metal filling in the plurality of trenches from each other.

14. The method of claim 12, wherein the step of forming the lower portion (21) of the pick-up coil comprises the steps of:
depositing a seed layer on an upper portion of the semiconductor substrate;
applying a photosensitive material on an upper portion of the seed layer, and forming a plating flask through exposure and developing;
plating through the plating flask; and
removing the plating flask.

15. The method of claim 12, wherein the step of forming the lower portion (23) of the excitation coil, the step of forming the upper portion (27) of the excitation coil and the step of forming the upper portion (29) of the pick-up coil each comprises the steps of:
applying the photosensitive material on the upper portion of the insulating layer which was deposited previously;
forming a pattern by using an exposure with respect to the photosensitive material;
forming a plating flask by etching the photosensitive material in accordance with the pattern;
forming a seed layer on the upper portion of the semiconductor substrate in which the photosensitive material is etched in accordance with the pattern;
plating the substrate in which the seed layer is formed;
polishing the upper surface of the semiconductor substrate to insulate the metal filling in the etched area from each other; and
removing the plating flask from the semiconductor substrate.

16. The method of claim 12, wherein the step of forming the lower portion (23) of the excitation coil, the step of forming the upper portion (27) of the excitation coil and the step of forming the upper portion (29) of the pick-up coil each comprises the steps of:
depositing a seed layer on the upper portion of the insulating layer which was deposited previously;
applying a thick photo resist on the upper portion of the seed layer;
forming a pattern by using an exposure with respect to the thick photo resist;
forming a plating flask by etching along the pattern;
plating through the plating flask; and
polishing the upper surface of the semiconductor substrate to insulate the metal filling in the etched area from each other; and
removing the plating flask and the seed layer at the lower portion of the plating flask from the semiconductor substrate.

17. The method of claim 12, wherein the soft magnetic core comprises two bars (1,2) disposed in the same plane and in parallel.

18. The method of claim 17, wherein the two bars (1,2) are formed such that their lengths are each in the direction of magnetic field detection.

19. The method of claim 12, wherein the soft magnetic core is formed as a rectangular ring.

20. The method of claim 19, wherein the rectangular-ring is formed such that its length is in the direction of magnetic field detection, and wherein opposite sides of the rectangle define two parallel bars.

21. The method of claim 18 or 20, wherein the excitation coil has a structure of alternately winding the two bars substantially in a figure of 8 pattern.

22. The method of claim 21, wherein the pick-up coil (4) is formed on the excitation coil (3) and has a structure formed of winding the two bars altogether substantially in a solenoid pattern.

23. The method of claim 21, wherein the pick-up coil (4) is formed on the excitation coil (3) and has a structure formed of winding the two bars in series and substantially in a solenoid pattern.

24. The method of claim 18 or 20, wherein the excitation coil has a structure of winding the two bars in series and substantially in a solenoid pattern.

25. The method of claim 24, wherein the pick-up coil is formed on the excitation coil and has a structure formed of winding the two bars altogether substantially in a solenoid pattern.

26. The method of claim 24, wherein the pick-up coil is formed on the excitation coil and has a structure formed of winding the two bars in series and substantially in a solenoid pattern.

## Patentansprüche

1. Fluxgate-Sensor, der Folgendes umfasst:
einen weichmagnetischen Kern (25), der auf einem Halbleitersubstrat (20) ausgebildet ist;
eine Erregerspule (27, 23), die um den weichmagnetischen Kern (25) gewickelt ist und durch eine auf die Ober- und die Unterseite des weichmagnetischen Kerns (25) abgesetzte Isolierschicht (24, 20) isoliert wird; und
eine Aufnehmerspule (21, 29), die um den weichmagnetischen Kern (25) gewickelt und durch eine auf die Ober- und die Unterseite (27, 23) der Erregerspule abgesetzte Isolierschicht (22, 28) isoliert ist, wobei die Erregerspule und die Aufnehmerspule einander überlappen.

2. Fluxgate-Sensor nach Anspruch 1, wobei der weichmagnetische Kern (25) zwei parallele Stäbe (1, 2) umfasst, die jeweils in derselben Ebene angeordnet sind.

3. Fluxgate-Sensor nach Anspruch 2, wobei die Länge der beiden Stäbe (1, 2) in Richtung der Magnetfelddetektion verläuft.

4. Fluxgate-Sensor nach Anspruch 1, wobei der weichmagnetische Kern als ein rechteckiger Ring ausgebildet ist.

5. Fluxgate-Sensor nach Anspruch 4, wobei die Länge des rechteckigen Rings in Richtung der Magnetfelddetektion verläuft und wobei gegenüberliegende Seiten des Rechtecks zwei parallele Stäbe definieren.

6. Fluxgate-Sensor nach Anspruch 3 oder 5, wobei die Erregerspule (3) eine Struktur mit abwechselnden Wicklungen um die beiden Stäbe im Wesentlichen in Form einer Acht hat.

7. Fluxgate-Sensor nach Anspruch 6, wobei die Aufnehmerspule (4) eine Struktur hat, die durch Wickeln der beiden Stäbe zusammen im Wesentlichen in einem Solenoid-Muster gebildet ist.

8. Fluxgate-Sensor nach Anspruch 6, wobei die Aufnehmerspule (4) eine Struktur hat, die durch Wickeln der beiden Stäbe in Serie und im Wesentlichen in einem Solenoid-Muster gebildet ist.

9. Fluxgate-Sensor nach Anspruch 6, wobei die Erregerspule eine Struktur hat, die durch Wickeln der beiden Stäbe in Serie und im Wesentlichen in einem Solenoid-Muster gebildet ist.

10. Fluxgate-Sensor nach Anspruch 9, wobei die Aufnehmerspule eine Struktur hat, die durch Wickeln der beiden Stäbe zusammen und im Wesentlichen in einem Solenoid-Muster gebildet ist.

11. Fluxgate-Sensor nach Anspruch 9, wobei die Aufnehmerspule eine Struktur hat, die durch Wicklung der beiden Stäbe in Serie und im Wesentlichen in einem Solenoid-Muster gebildet ist.

12. Verfahren zur Herstellung eines Fluxgate-Sensors, das die folgenden Schritte beinhaltet:
Bilden eines unteren Abschnitts (21) einer Aufnehmerspule auf einem oberen Abschnitt eines Halbleitersubstrats (20);
Absetzen einer ersten Isolierschicht (22) auf dem oberen Abschnitt des Halbleitersubstrats (20), in dem der untere Abschnitt (21) der Aufnehmerspule ausgebildet ist, und Bilden eines unteren Abschnitts (23) einer Erregerspule entsprechend der Aufnehmerspule;
Absetzen einer Isolierschicht (24) auf einer Oberseite des unteren Abschnitts (23) der Erregerspule, und zunächst Bilden erster Durchkontaktierungslöcher zum elektrischen Verbinden mit dem unteren Abschnitt (23) der Erregerspule;
Bilden eines weichmagnetischen Kerns (25) auf einem oberen Abschnitt der Isolierschicht, in dem die ersten Durchkontaktierungslöcher ausgebildet sind, so dass sie entsprechend der Aufnehmerspule und der Erregerspule angeordnet sind;
Absetzen einer Isolierschicht (26) auf einem oberen Abschnitt des weichmagnetischen Kerns (25), und zweites Bilden der ersten Durchkontaktierungslöcher zum elektrischen Verbinden mit dem unteren Abschnitt der Erregerspule;
Bilden des oberen Abschnitts (27) der Erregerspule entsprechend dem unteren Abschnitt (23) der Erregerspule auf einem oberen Abschnitt der Isolierschicht (26), in der die zweitgeformten ersten Durchkontaktierungslöcher ausgebildet sind, wobei der obere Abschnitt (27) der Erregerspule elektrisch mit dem unteren Abschnitt (23) der Erregerspule verbunden ist;
Absetzen einer Isolierschicht (28) auf dem oberen Abschnitt (27) der Erregerspule und Bilden von zweiten Durchkontaktierungslöchern, die elektrisch mit dem unteren Abschnitt der Aufnehmerspule verbunden sind; und
Bilden eines oberen Abschnitts (29) der Aufnehmerspule entsprechend dem unteren Abschnitt (21) der Aufnehmerspule auf dem oberen Abschnitt der Isolierschicht (28), in der die zweiten Durchkontaktierungslöcher ausgebildet sind, wobei der obere Abschnitt (29) der Aufnehmerspule elektrisch mit dem unteren Abschnitt (21) der Aufnehmerspule verbunden ist.

13. Verfahren nach Anspruch 12, wobei der Schritt des Bildens des unteren Abschnitts (21) der Aufnehmerspule die folgenden Schritte beinhaltet:
Bilden mehrerer Gräben vom oberen zum unteren Abschnitt des Halbleitersubstrats, wobei die Gräben eine große Schnittfläche bei geringer Teilungsgröße haben;
Absetzen, durch Vakuumverdampfung, einer Seed-Schicht auf einer Oberseite des Halbleitersubstrats mit den darin ausgebildeten mehreren Gräben;
Plattieren der Oberseite des Halbleitersubstrats mit der darauf abgesetzten Seed-Schicht; und
Polieren der Oberseite des Halbleitersubstrats, um die Metallfüllung in den mehreren Gräben voneinander zu isolieren.

14. Verfahren nach Anspruch 12, wobei der Schritt des Bildens des unteren Abschnitts (21) der Aufnehmerspule die folgenden Schritte beinhaltet:
Absetzen einer Seed-Schicht auf einem oberen Abschnitt des Halbleitersubstrats;
Aufbringen eines fotosensitiven Materials auf einen oberen Abschnitt der Seed-Schicht und Bilden einer Plattierungsform durch Belichten und Entwickeln;
Plattieren durch die Plattierungsform; und
Entfernen der Plattierungsform.

15. Verfahren nach Anspruch 12, wobei der Schritt des Bildens des unteren Abschnitts (23) der Erregerspule, der Schritt des Bildens des oberen Abschnitts (27) der Erregerspule und der Schritt des Bildens des oberen Abschnitts (29) der Aufnehmerspule jeweils die folgenden Schritte beinhalten:
Aufbringen des fotosensitiven Materials auf den oberen Abschnitt der zuvor abgesetzten Isolierschicht;
Bilden eines Musters mittels Belichtung mit Bezug auf das fotosensitive Material;
Bilden einer Plattierungsform durch Ätzen des fotosensitiven Materials gemäß dem Muster;
Bilden einer Seed-Schicht auf dem oberen Abschnitt des Halbleitersubstrats, in dem das fotosensitive Material gemäß dem Muster geätzt wurde;
Plattieren des Substrats, in dem die Seed-Schicht ausgebildet ist;
Polieren der Oberseite des Halbleitersubstrats, um die Metallfüllung im geätzten Bereich voneinander zu isolieren; und
Entfernen der Plattierungsform von dem Halbleitersubstrat.

16. Verfahren nach Anspruch 12, wobei der Schritt des Bildens des unteren Abschnitts (23) der Erregerspule, der Schritt des Bildens des oberen Abschnitts (27) der Erregerspule und der Schritt des Bildens des oberen Abschnitts (29) der Aufnehmerspule jeweils die folgenden Schritte beinhalten:
Absetzen einer Seed-Schicht auf dem oberen Abschnitt der zuvor abgesetzten Isolierschicht;
Aufbringen eines dicken Fotoresists auf den oberen Abschnitt der Seed-Schicht;
Bilden eines Musters mittels einer Belichtung mit Bezug auf den dicken Fotoresist;
Bilden einer Plattierungsform durch Ätzen entlang dem Muster;
Plattieren durch die Plattierungsform; und
Polieren der Oberseite des Halbleitersubstrats, um die Metallfüllung in dem geätzten Bereich voneinander zu isolieren; und
Entfernen der Plattierungsform und der Seed-Schicht am unteren Abschnitt der Plattierungsform von dem Halbleitersubstrat.

17. Verfahren nach Anspruch 12, wobei der weichmagnetische Kern zwei Stäbe (1, 2) umfasst, die in derselben Ebene und parallel angeordnet sind.

18. Verfahren nach Anspruch 17, wobei die beiden Stäbe (1, 2) so ausgebildet sind, dass ihre Längen jeweils in der Richtung der Magnetfelddetektion verlaufen.

19. Verfahren nach Anspruch 12, wobei der weichmagnetische Kern als ein rechteckiger Ring ausgebildet ist.

20. Verfahren nach Anspruch 19, wobei der rechteckige Ring so gebildet ist, dass seine Länge in der Richtung der Magnetfelddetektion verläuft, und wobei gegenüberliegende Seiten des Rechtecks zwei parallele Stäbe definieren.

21. Verfahren nach Anspruch 18 oder 20, wobei die Erregerspule eine Struktur des abwechselnden Wickelns der beiden Stäbe im Wesentlichen in Form einer Acht hat.

22. Verfahren nach Anspruch 21, wobei die Aufnehmerspule (4) auf der Erregerspule (3) ausgebildet ist und eine Struktur hat, die durch Wickeln der beiden Stäbe zusammen im Wesentlichen in einem Solenoid-Muster gebildet ist.

23. Verfahren nach Anspruch 21, wobei die Aufnehmerspule (4) auf der Erregerspule (3) ausgebildet ist und eine Struktur hat, die durch Wickeln der beiden Stäbe in Serie und im Wesentlichen in einem Solenoid-Muster gebildet ist.

24. Verfahren nach Anspruch 18 oder 20, wobei die Erregerspule eine Struktur hat, die durch Wickeln der beiden Stäbe in Serie und im Wesentlichen in einem Solenoid-Muster gebildet ist.

25. Verfahren nach Anspruch 24, wobei die Aufnehmerspule auf der Erregerspule ausgebildet ist und eine Struktur hat, die durch Wickeln der beiden Stäbe zusammen im Wesentlichen in einem Solenoid-Muster gebildet ist.

26. Verfahren nach Anspruch 24, wobei die Aufnehmerspule auf der Erregerspule ausgebildet ist und eine Struktur hat, die durch Wickeln der beiden Stäbe in Serie und im Wesentlichen in einem Solenoid-Muster gebildet ist.

## Revendications

1. Capteur à grille de flux, comprenant :
un noyau magnétique souple (25) formé sur un substrat semiconducteur (20) ;
une bobine d'excitation (27, 23) enroulant le noyau magnétique souple (25) et étant isolée par une couche isolante (24, 20) déposée sur les côtés supérieur et inférieur du noyau magnétique souple (25) ; et
une bobine de détection (21, 29), enroulant le noyau magnétique souple (25) et étant isolée par une couche isolante (22, 28) déposée sur les côtés supérieur et
inférieur (27, 23) de la bobine d'excitation, dans lequel la bobine d'excitation et la bobine de détection se chevauchent.

2. Capteur à grille de flux selon la revendication 1, dans lequel le noyau magnétique souple (25) comprend deux barres parallèles (1, 2) chacune étant disposée dans le même plan.

3. Capteur à grille de flux selon la revendication 2, dans lequel les deux barres (1, 2) ont leur longueur dans une direction de détection de champ magnétique.

4. Capteur à grille de flux selon la revendication 1, dans lequel le noyau magnétique souple est formé comme un anneau rectangulaire.

5. Capteur à grille de flux selon la revendication 4, dans lequel l'anneau rectangulaire a sa longueur dans la direction de détection du champ magnétique, et dans lequel les côtés opposés du rectangle définissent deux barres parallèles.

6. Capteur à grille de flux selon la revendication 3 ou la revendication 5, dans lequel la bobine d'excitation (3) a une structure d'enroulement alternatif des deux barres selon un motif substantiellement en huit.

7. Capteur à grille de flux selon la revendication 6, dans lequel la bobine de détection (4) a une structure formée d'enroulement des deux barres ensemble selon un motif substantiellement de solénoïde.

8. Capteur à grille de flux selon la revendication 6, dans lequel la bobine de détection (4) a une structure formée d'enroulement des deux barres en série et selon un motif substantiellement de solénoïde.

9. Capteur à grille de flux selon la revendication 6, dans lequel la bobine d'excitation a une structure d'enroulement des deux barres en série et selon un motif substantiellement de solénoïde.

10. Capteur à grille de flux selon la revendication 9, dans lequel la bobine de détection a une structure formée d'enroulement des deux barres ensemble selon un motif substantiellement de solénoïde.

11. Capteur à grille de flux selon la revendication 9, dans lequel la bobine de détection a une structure formée d'enroulement des deux barres en série et selon un motif substantiellement de solénoïde.

12. Procédé de fabrication d'un capteur à grille de flux, comprenant les étapes consistant à :
former une portion inférieure (21) d'une bobine de détection sur une portion supérieure d'un substrat semiconducteur (20) ;
déposer une première couche isolante (22) sur la portion supérieure du substrat semiconducteur (20) dans lequel la portion inférieure (21) de la bobine de détection est formée, et former la portion inférieure (23) d'une bobine d'excitation correspondant à la bobine de détection ;
déposer une couche isolante (24) sur une surface supérieure de la portion inférieure (23) de la bobine d'excitation, et former tout d'abord des premiers trous de raccordement pour raccorder électriquement la portion inférieure (23) de la bobine d'excitation ;
former un noyau magnétique souple (25) sur une portion supérieure de la couche isolante qui est dotée des premiers trous de raccordement, pour correspondre dans l'agencement à la bobine de détection et à la bobine d'excitation ;
déposer une couche isolante (26) sur une portion supérieure du noyau magnétique souple (25), et ensuite former les premiers trous de raccordement pour raccorder électriquement la portion inférieure de la bobine d'excitation ;
former une portion supérieure (27) de la bobine d'excitation correspondant à la portion inférieure (23) de la bobine d'excitation sur une portion supérieure de la couche isolante (26) qui est dotée des premiers trous de raccordement formés ensuite, la portion supérieure (27) de la bobine d'excitation étant raccordée électriquement à la portion inférieure (23) de la bobine d'excitation ;
déposer une couche isolante (28) sur la portion supérieure (27) de la bobine d'excitation et former des deuxièmes trous de raccordement raccordant électriquement la portion inférieure de la bobine de détection ; et
former une portion supérieure (29) de la bobine de détection correspondant à la portion inférieure (21) de la bobine de détection sur la portion supérieure de la couche isolante (28) qui est dotée des deuxièmes trous de raccordement, la portion supérieure (29) de la bobine de détection étant raccordée électriquement à la portion inférieure (21) de la bobine de détection.

13. Procédé selon la revendication 12, dans lequel l'étape consistant à former la portion inférieure (21) de la bobine de détection comprend les étapes consistant à :
former une pluralité de tranchées depuis la portion supérieure vers la portion inférieure du substrat semiconducteur, les tranchées ayant un taux élevé de surface de coupe et une petite taille de pas ;
déposer par évaporation sous vide une couche de germination sur une surface supérieure du substrat semiconducteur sur laquelle une pluralité de tranchées a été formée ;
procéder à un placage de la surface supérieure du substrat semiconducteur sur laquelle une couche de germination a été déposée ; et
polir la surface supérieure du substrat semiconducteur pour isoler les garnissages de métal dans la pluralité de tranchées les uns des autres.

14. Procédé selon la revendication 12, dans lequel l'étape consistant à former la portion inférieure (21) de la bobine de détection comprend les étapes consistant à :
déposer une couche de germination sur une portion supérieure du substrat semiconducteur ;
appliquer un matériau photosensible sur une portion supérieure de la couche de germination ; et
former un châssis de placage par exposition et développement ;
procéder au placage au travers du châssis de placage ; et
retirer le châssis de placage.

15. Procédé selon la revendication 12, dans lequel l'étape de formation de la portion inférieure (23) de la bobine d'excitation, l'étape de formation de la portion supérieure (27) de la bobine d'excitation et l'étape de formation de la portion supérieure (29) de la bobine de détection comprennent chacune les étapes consistant à :
appliquer le matériau photosensible sur la portion supérieure de la couche isolante qui a été déposée précédemment ;
former un motif en utilisant une exposition du matériau photosensible ;
former un châssis de placage en gravant le matériau photosensible selon le motif ;
former une couche de germination sur la portion supérieure du substrat semiconducteur dans lequel le matériau photosensible est gravé selon le motif ;
plaquer le substrat dans lequel la couche de germination est formée ;
polir la surface supérieure du substrat semiconducteur pour isoler les garnissages de métal dans la surface gravée les uns des autres ; et
retirer le châssis de placage du substrat semiconducteur.

16. Procédé selon la revendication 12, dans lequel l'étape de formation de la portion inférieure (23) de la bobine d'excitation, l'étape de formation de la portion supérieure (27) de la bobine d'excitation et l'étape de formation de la portion supérieure (29) de la bobine de détection comprennent chacune les étapes consistant à :
déposer une couche de germination sur la portion supérieure de la couche isolante qui a été déposée précédemment ;
appliquer une couche photorésistante épaisse sur la portion supérieure de la couche de germination ;
former un motif en utilisant une exposition de la couche photorésistante épaisse ;
former un châssis de placage en gravant le long du motif ;
procéder au placage au travers du châssis de placage ; et
polir la surface supérieure du substrat semiconducteur pour isoler les garnissages de métal dans la surface gravée les uns des autres ; et
retirer le châssis de placage et la couche de germination au niveau de la portion inférieure du châssis de placage du substrat semiconducteur.

17. Procédé selon la revendication 12, dans lequel le noyau magnétique souple comprend deux barres (1, 2) disposées dans le même plan et en parallèle.

18. Procédé selon la revendication 17, dans lequel les deux barres (1, 2) sont formées de façon telle que leurs longueurs sont chacune dans la direction de détection du champ magnétique.

19. Procédé selon la revendication 12, dans lequel le noyau magnétique souple est formé comme un anneau rectangulaire.

20. Procédé selon la revendication 19, dans lequel l'anneau rectangulaire est formé de façon à ce que sa longueur soit dans la direction de détection du champ magnétique, et dans lequel les côtés opposés du rectangle définissent deux barres parallèles.

21. Procédé selon la revendication 18 ou la revendication 20, dans lequel la bobine d'excitation a une structure d'enroulement alternatif des deux barres selon un motif substantiellement en huit.

22. Procédé selon la revendication 21, dans lequel la bobine de détection (4) est formée sur la bobine d'excitation (3) et a une structure formée d'enroulement des deux barres ensemble selon un motif substantiellement de solénoïde.

23. Procédé selon la revendication 21, dans lequel la bobine de détection (4) est formée sur la bobine d'excitation (3) et a une structure formée d'enroulement des deux barres en série et selon un motif substantiellement de solénoïde.

24. Procédé selon la revendication 18 ou la revendication 20, dans lequel la bobine d'excitation a une structure d'enroulement des deux barres en série et selon un motif substantiellement de solénoïde.

25. Procédé selon la revendication 24, dans lequel la bobine de détection est formée sur la bobine d'excitation et a une structure formée d'enroulement des deux barres ensemble selon un motif substantiellement de solénoïde.

26. Procédé selon la revendication 24, dans lequel la bobine de détection est formée sur la bobine d'excitation et a une structure formée d'enroulement des deux barres en série et selon un motif substantiellement de solénoïde.
